# EUROPEAN PATENT APPLICATION

(11) **EP 4 794 481 A1**
(43) Date of publication of application: **19.08.2026**
(21) Application number: 26156433.0
(22) Date of filing: 04.02.2026
(51) Int. Cl.: H10D 89/60

(54) **ESD AND OVERVOLTAGE CLAMP**

(30) Priority: 14.02.2025 US 202519053765
(71) Applicant: NXP B.V., 5656 AG Eindhoven (NL)
(72) Inventor: Grad, Marcin, 5656 AG Eindhoven (NL); Kumar, Niraj, 5656 AG Eindhoven (NL)
(74) Representative: Schmütz, Christian Klaus Johannes

(57) **Abstract**

An ESD circuit includes a clamp that can be used for both discharging ESD current and for over voltage protection. The integrated circuit includes a signal IC terminal that is coupled to the clamp through a resistor circuit. In response to an over voltage condition of the signal IC terminal, the clamp becomes conductive to make conducive a discharge path between the signal IC terminal and a supply voltage rail to conduct charge to reduce the over voltage condition. The discharge path is through the resistor and through the clamp. A transistor is coupled to the control terminal of the clamp and has a control input coupled to receive an ESD trigger signal. In response to a detected ESD event, the trigger circuit is asserted to make the transistor conductive to pull the voltage of the control terminal of the clamp towards a voltage of the supply voltage rail to make conductive the discharge path to discharge ESD current between the IC terminal and the supply voltage rail.

## Description

### BACKGROUND OF THE INVENTION

### Field of the Invention

This invention relates to an integrated circuit (IC) with a clamp that is used for overvoltage and ESD protection.

### Background

Some semiconductor integrated circuits utilize electrostatic discharge (ESD) devices for discharging charge from an ESD event affecting an IC terminal. An ESD event may occur when a charged object (e.g., a human finger) inadvertently contacts a conductive surface of an integrated circuit (e.g., a contact pad, bump, post, or other type of IC terminal) or a conductive surface of an integrated circuit package coupled to the pad where charge at an elevated voltage is applied to the conductive surface due to the contact. Being at an elevated voltage, such charge may cause voltage differentials across the devices of the integrated circuit that may exceed their safe operating area voltages and damage those devices. An ESD event may also occur when a charged conductive surface of a circuit contacts an external object where charge is transferred between the conductive surface and the external object.

In some embodiments, ESD events may be intentionally caused by qualification testing preformed on an integrated circuit. During such tests, high voltages may occur at signal IC terminals due to an overshoot of injected test current.

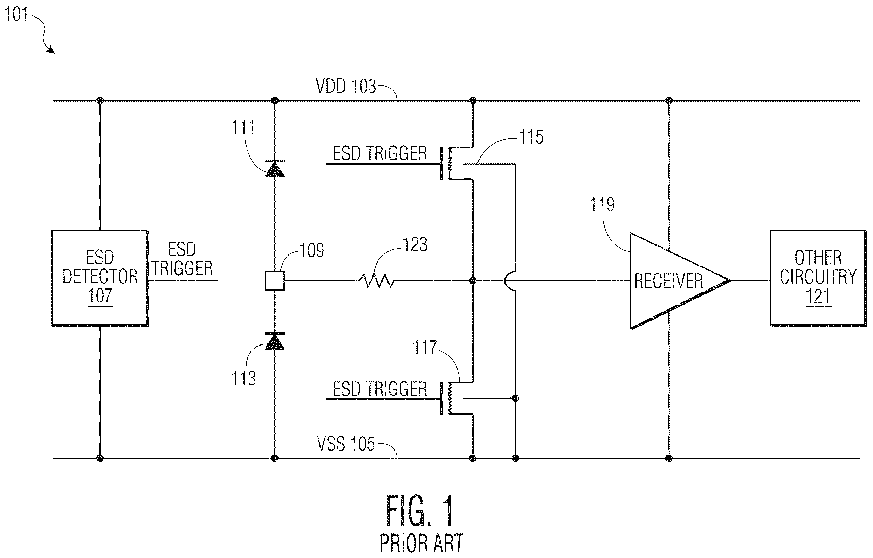

Figure 1 is a circuit diagram of circuitry of a prior art integrated circuit. Integrated circuit 101 includes an ESD detector circuit 107 for detecting ESD events. The ESD detector circuit 107 asserts an ESD trigger signal (ESD TRIGGER) in response to detecting an ESD event. Integrated circuit 101 includes an external integrated circuit pad 109. Diode 111 is connected between a VDD supply voltage rail 103 and pad 109. Diode 113 is connected between pad 109 and a VSS supply voltage rail 105. Circuit 101 includes receiver 119 for processing signals received on pad 109. Receiver 119 provides a signal to other circuitry 121 of integrated circuit 101.

Circuit 101 includes ESD clamps 115 and 117 which are implemented as NFETs. Clamps 115 and 117 are connected to the input of receiver 119. The drain of clamp 115 is connected to VDD supply voltage rail 103. The source of clamp 117 is connected to VSS supply voltage rail 105. The gates of clamps 115 and 117 are configured to receive the ESD TRIGGER signal. A resistor 123 is located in a signal path between pad 109 and receiver 119.

### BRIEF DESCRIPTION OF THE DRAWINGS

The present invention may be better understood, and its numerous objects, features, and advantages made apparent to those skilled in the art by referencing the accompanying drawings.
Figure 1 is a circuit diagram of a prior art circuit.
Figure 2 is a block diagram of an integrated circuit with drive circuitry and ESD circuitry that includes an overvoltage and ESD clamp according to one embodiment of the present invention.
Figure 3 is a block diagram of an integrated circuit with receiver circuitry and ESD circuitry that includes an overvoltage and ESD clamp according to one embodiment of the present invention.

The use of the same reference symbols in different drawings indicates identical items unless otherwise noted. The Figures are not necessarily drawn to scale.

### DETAILED DESCRIPTION

The following sets forth a detailed description of a mode for carrying out the invention. The description is intended to be illustrative of the invention and should not be taken to be limiting.

In one embodiment, an ESD circuit includes a clamp that can be used for both discharging ESD current and for over voltage protection. The integrated circuit includes a signal IC terminal that is coupled to the clamp through a resistor circuit. In response to an over voltage condition of the signal IC terminal, the clamp becomes conductive to make conducive a discharge path between the signal IC terminal and a supply voltage rail to conduct charge to reduce the over voltage condition. The discharge path is through the resistor and through the clamp. A transistor is coupled to the control terminal of the clamp and has a control input coupled to receive an ESD trigger signal. In response to a detected ESD event, the trigger circuit is asserted to make the transistor conductive to pull the voltage of the control terminal of the clamp towards a voltage of the supply voltage rail to make conductive the discharge path to discharge ESD current between the IC terminal and the supply voltage rail.

One advantage of such a configuration in an integrated circuit is that the clamp and discharge path can be used for both overvoltage protection and for ESD protection for protecting circuitry coupled to the signal IC terminal wherein the clamp is not conductive during normal operation. In some embodiments, such a solution may provide for both overvoltage and ESD protection while minimizing the capacitance added to the signal path due to the discharge path. In other embodiments, such a circuit may allow for the IC to be implemented with lower voltage devices (e.g. such as transistors with thinner gate dielectrics, of smaller process nodes, and/or of more compact configurations such as FinFETS) in the circuit.

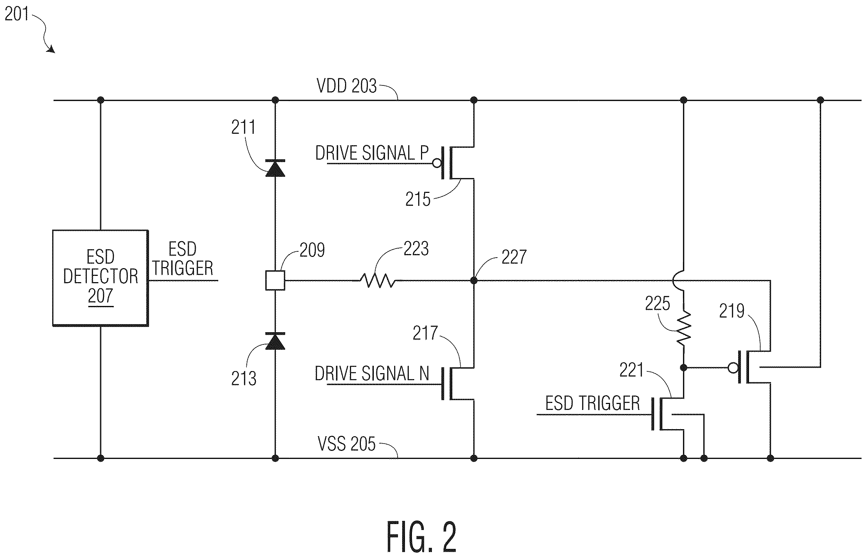

Figure 2 is a circuit diagram of a portion of an integrated circuit 201 according to one embodiment of the present invention. Integrated circuit 201 includes a signal IC terminal 209. In one embodiment, IC terminal 209 is implemented as a conductive pad found on the exterior of an integrated circuit, but may be implemented with other types of IC terminals such as e.g., a conductive bump, ball, or pillar that are found on the exterior of an integrated circuit. Terminal 209 is characterized as a signal IC terminal in that it is used to convey a signal between the integrated circuit 201 and external circuitry (not shown) as opposed to a supply voltage terminal.

In some embodiments, terminal 209 may be an output signal terminal in that it only outputs signals from integrated circuit 201 to external circuitry. In other embodiments terminal may also be used to receive signals from external circuitry as well.

Integrated circuit 201 includes a VDD supply voltage rail 203 and a VSS supply voltage rail 205. VDD supply voltage rail 203 is coupled to a supply voltage IC terminal (not shown) of integrated circuit 201. VDD supply voltage rail 203 provides a supply voltage (such as e.g., 1.8 V, or other supply voltage) to circuitry of integrated circuit 201. VSS supply voltage rail 205 is coupled to a supply voltage IC terminal (not shown) of integrated circuit 201. VSS supply voltage rail 205 provides a supply voltage (such as e.g., ground or a negative supply voltage) to circuitry of integrated circuit 201 that is lower than VDD.

Integrated circuit 201 includes a diode 211 with its anode connected to terminal 209 and its cathode connected to VDD supply voltage rail 203. Integrated circuit 201 also includes a diode 213 with its anode connected to VSS supply voltage rail 205 and its cathode connected to terminal 209. Diodes 213 and 211 are utilized for discharging ESD charge from terminal 209 to VDD supply rail 203 and to VSS supply voltage rail 205.

In the embodiment of Figure 2, integrated circuit 201 includes drive circuitry for driving a signal on terminal 209 to external circuitry. In Figure 2, the drive circuitry is implemented with a PFET 215 and an NFET 217. PFET 215 includes a source connected to supply voltage rail 203 and a drain connected to node 227. NFET 217 includes a source connected to VSS supply voltage rail 205 and a drain connected to node 227. The gates of PFET 215 and NFET 217 are configured to receive drive signals DRIVE SIGNAL P and DRIVE SIGNAL N, respectively, that are used to produce an output signal at node 227 that is driven via a signal path that includes resister 223 to signal IC terminal 209, wherein it is outputted to other circuitry external to integrated circuit 201 (not shown). However, other integrated circuits of other embodiments may include other types of drive circuitry for producing output signals, e.g., such as a stacked MOS driver. In the embodiment of Figure 2, the output signal is a digital signal. However, the output signal may be an analog signal in other embodiments. In some embodiments, the signal outputted at terminal 209 may be part of a differential signal with a complementary signal being outputted at another signal IC terminal (not shown).

Integrated circuit 201 includes a discharge path for conducting charge between signal IC terminal 209 and VSS supply voltage rail 205 during an ESD event or during an over voltage condition. The discharge path includes a clamp, which is implanted with a PFET 219 in Figure 2, for controlling whether the discharge path is conductive. When the discharge path is made conductive by PFET 219 being conductive, current flows between terminal 209 and VSS supply voltage rail 205, through resistor 223 and through PFET 219. PFET 219 includes a source connected to node 227, and a drain and body terminal connected to VSS supply voltage rail 205. The gate of PFET 219 is connected to a terminal of resistor 225. The other terminal of resistor 225 is connected to VDD supply voltage rail 203. The gate of PFET 219 is also connected to the drain of NFET 221. NFET 221 includes a source and a body terminal that are connected to VSS supply voltage rail 205.

The gate of NFET 221 is connected to the output of the ESD detector 207 to receive an ESD TRIGGER signal. The ESD detector circuit asserts the ESD TRIGGER signal in response to a detection of an ESD event affecting rail 203. In other embodiments, ESD detector 207 may assert the ESD Trigger signal in response to a detection of an ESD event affecting other structures of integrated circuit 201. In some embodiments, detector 207 includes a transient detector circuit (e.g. such as an RC detector circuit) that detects a rising voltage of rail 203 with respect to rail 205 having a fast transient that is indicative of an ESD event as to opposed to an event with a slower transient such as a power-on event. Integrated circuit 201 may include other clamps (not shown) that are made conductive in response to the assertion of the ESD TRIGGER signal.

In other embodiments, the ESD detector 207 may be coupled to an ESD bus (not shown) that is coupled to multiple IC terminals (e.g., both supply voltage terminal and signal terminals) such that an ESD event affecting any one of the terminals would cause detector 207 to assert the ESD TRIGGER signal. In some embodiments with an ESD bus (not shown), diode 211 may be connected to the ESD bus instead of rail 203. Integrated circuit 201 may include other clamps (not shown) that are made conductive in response to the assertion of the ESD TRIGGER signal. In some embodiments, the ESD bus is coupled rail 203 via one or more diodes, resistors or switches (not shown).

When the ESD TRIGGER signal is asserted in response to an ESD event, NFET 221 is made conductive to pull the voltage of the gate of PFET 219 towards the voltage of VSS. When the voltage of the gate of PFET 219 fall below the voltage threshold of PFET 219 from the voltage of node 227, PFET 219 becomes conductive to make conducive the discharge path from terminal 209 to rail 205 through resistor 223 and through PFET 219 to discharge ESD current to rail 205. Once detector 207 de-asserts the ESD TRIGGER signal, NFET 221 becomes nonconductive where the voltage of PFET 219 is no longer pulled toward the voltage of rail 205. Accordingly, resistor 225 and NFET 221 act like an inverter in making PFET 219 conductive in response to the assertion of the ESD TRIGGER signal.

When the ESD TRIGGER signal is not asserted, the discharge path between terminal 209 and rail 205 through resistor 223 and through PFET 219 can also be made conductive in response to an overvoltage condition at terminal 209 with respect to the voltage of rail 203. When the voltage of node 227 exceeds the voltage of the gate of PFET 219 by the threshold voltage of PFET 219 (e.g..35 V in some embodiments), PFET 219 becomes conductive to discharge current from terminal 209 to rail 205. The discharge path is conductive until the voltage of the source of PFET 219 falls within a voltage threshold of the voltage of the gate of PFET 219.

During an ESD event or overvoltage condition, current flowing through resistor 223 produces a voltage drop across resistor 223 so as to lower the voltage of node 227 from the elevated voltage of terminal 209. Accordingly, the voltage across NFET 217 during an ESD event or overvoltage condition is reduced. Consequently, NFET 217 can be implemented with transistors with a lesser degree of "voltage hardening features" such as e.g. with thinner gate oxides or minimal drain extension regions. Transistors having a higher degree of these features typically result in transistors with a higher capacitance, which may be detrimental to a desired operation especially with high frequency signals (e.g. 1 GHz and above). Accordingly, implementing a resistor in the discharge path between the terminal and a protected device (e.g. NFET 217) may allow for the protected device to be implemented with a "lower capacitance" device. In one embodiment, the transistors of Figure 2 are implemented with FinFETs.

Resistor 225 generates a voltage drop during an ESD event affecting rail 203. Accordingly, the voltage of the gate of PFET 219 can be pulled towards the voltage of VSS rail 205 without having to pull the voltage of rail 203 towards the voltage of rail 205 to turn on PFET 219. This allows PFET 219 to be turned on faster and/or allows for NFET 221 to be implemented with a smaller transistor. Resistor 225 may also provide protection for NFET 221 during an ESD event affecting rail 203.

Integrated circuit 201 is implemented in a packaged integrated circuit (not shown). In some embodiments, IC terminal 209 is electrically coupled to a packaged terminal such as e.g., a bond pad, pin, ball, or bump of the package, which can be attached to a conductive structure of a system that utilizes the integrated circuit. In some embodiments, integrated circuit 201 is implanted in an IC package with multiple integrated circuits where terminal 209 is coupled to an IC terminal of another integrated circuit in the package.

In some embodiments, the discharge path of Figure 2 can be used to discharge current from terminal 209 of an ESD event or over voltage condition when the integrated circuit is not powered up. In some embodiments, integrated circuit 201 may include other clamp devices (not shown) that also discharge ESD current from an ESD event in addition to the current flowing through the discharge path.

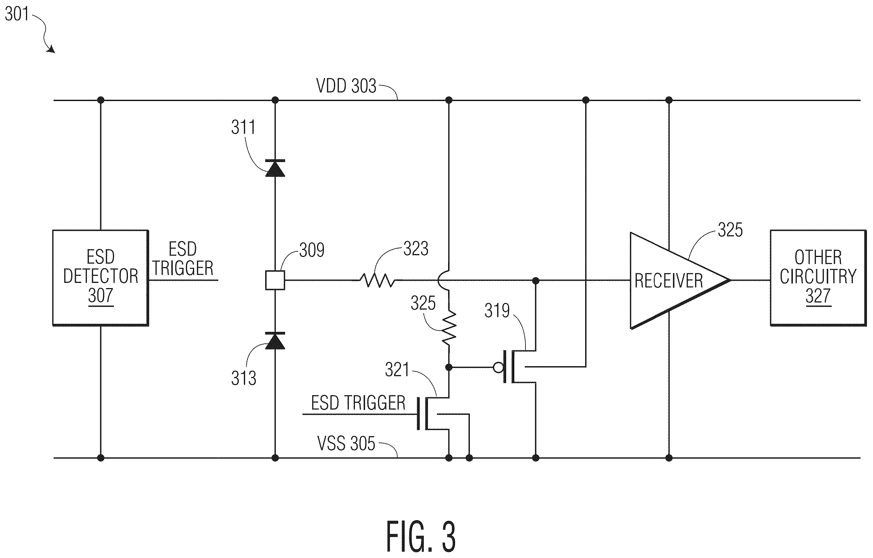

Figure 3 is a circuit diagram of a portion of an integrated circuit 301 according to one embodiment of the present invention. Integrated circuit 301 includes an IC terminal 309 for receiving an external signal and a receiver 325 for processing the signal. Integrated circuit 301 includes PFET 319, NFET 321, and resistor 325 for implementing a discharge path between terminal 309 and VSS supply voltage rail 305 through resistor 323 and through PFET 319 for discharging current for a detected ESD event or an overvoltage condition. PFET 319, NFET 321, and resistor 325 operate in a similar manner as PFET 219, NFET 221, and resistor 225, respectively, of Figure 2 in providing the discharge path. ESD detector 307, diode 311, diode 313, VDD supply voltage rail 303 and VSS supply voltage rail 305 are similar to ESD detector 207, diode 211, diode 213, VDD supply voltage rail 203, and VSS supply voltage rail 205, respectively, of Figure 2.

Receiver 325 includes an input to receive an external signal that was received by integrated circuit 301 at terminal 309 and provided to the input via a signal path through resistor 323. The signal may be a digital signal in some embodiments or an analog signal in some embodiments. In some embodiments, the signal may be part of a differential signal with a complementary signal being received at another IC terminal (not shown). In some embodiments, receiver 325 may include an amplifier, level shifter, and/or more complex receiving circuitry such as demodulator, buffer, or A/D converter. Receiver 325 provides a processed signal to other circuitry 327 of integrated circuit 301 based on the received signal.

In some embodiments, the received signal is a high-speed digital signal (e.g., at a frequency greater than 1 GHz). In some embodiments, the received signal is an ethernet signal. Utilizing the clamp (PFET 319)/transistor (NFET 321) configuration for ESD and overvoltage protection, may in some embodiments, provide for a lower capacitance solution for providing ESD and overvoltage protection in that PFET 319 and NFET 321 are nonconductive during normal operation.

During an ESD event, resistor 323 provides a voltage drop from the elevated voltage of terminal 309 to the input of receiver 325. This voltage drops acts to protect the devices of receiver 325 particularly NFETs (not shown) during an ESD event or overvoltage condition.

In some high-speed applications, resistor 323 may cause filtering issues in the signal path to receiver 325. Accordingly in some embodiments, it may be desirable for the resistance of resistor 323 to be as small as effectively possible. In some examples, resistor 323 has a resistance of 500 ohms, but may be of other resistances in other embodiments. In some embodiments, the size of the resistor would be dependent upon the frequency of the signal being received. In some embodiments, the width of PFET 319 can be made larger to compensate for the reduction in resistance of resistor 323. However, a larger resistor of resistor 323 may allow for a reduction in the width of PFET 319.

In some embodiments, terminals 209 and 309 may be located on the same integrated circuit. In some embodiments, both terminals would be coupled to the same supply voltages rails (VDD and VSS) through diodes, although they may be coupled to different supply voltage rails of the integrated circuit in other embodiments. In some embodiments, the gates of NFETs 231 and 321 would be coupled to the same ESD detector to receive a common ESD TRIGGER signal. Thus, an assertion of the ESD TRIGGER signal would cause both NFET 221 and NFET 321 to become conductive in response to a detection of an ESD event. In some embodiments, all signal IC terminals of an IC would include an associative discharge path (with an NFET similar to NFET 221 or NFET 321 and a PFET similar to PFET 219 or PFET 319). In some embodiments, a signal IC terminal would be configured to both receive a signal and to output a signal.

In other embodiments, other types of clamps may be used in place of PFET 219 or PFET 319 including other types of transistors (e.g., such as a PNP transistor) or multi transistor clamps. Also, other types of resistive circuits may be used in other embodiments such as fixed biased transistors or multiple resistor circuits. In other embodiments, the terminals of resistors 225 or 325 may be connected to another type of voltage node (e.g. a voltage reference source output) other than a VDD supply voltage rail.

In some embodiments, multiple discharge paths may be coupled to a signal IC terminal. For example, referring back to Figure 2, integrated circuit 201 may include multiple sets of driver circuity where each set includes a PFET and an NFET (similar to PFET 215 and NFET 217), a path resistor (similar to path resistor 223), a drive node (similar to drive node 227) and a clamp (similar to PFET 219) of the configuration shown in Figure 2. Each path resistor of each set would be connected to the signal IC terminal 209. In some embodiments, each path resistor would be of a different resistive value. One or more of the drive circuitry sets may be enabled at a time to drive a signal on signal IC terminal 209. In some embodiments, each driver circuitry set would include an NFET similar to NFET 221 that is responsive to the ESD TRIGGER signal. In other embodiments, the drain of NFET 221 would be connected to the clamp control terminal (the gate of the PFETs similar to PFET 219) of all of the clamps of the drive circuitry sets to pull down the control terminal voltage of the clamps in response to an ESD event.

Also in other embodiments, resistor 225 or resistor 325 would be replaced with a PFET (not shown) having a drain that is connected to the gate of PFET 219, a source connected to VDD rail 203, and a gate that is configured to receive the ESD TRIGGER signal.

As described herein, providing a discharge path between a signal IC terminal and a supply voltage rail that includes a resistor and clamp in the path and a transistor coupled to the control terminal of the clamp may provide for circuitry that can perform both overvoltage and ESD protection functions for protecting devices coupled to the signal IC terminal. Furthermore, such a circuit can be implemented with devices of relatively low capacitance, so as to provide a minimal effect on the operation of the circuit. Furthermore, providing such a circuit may allow for the input or output circuitry of an IC to be made with devices that are less "ESD hardened" (e.g., includes thinner gate oxides, smaller drain extension regions, or stacking of devices). Such a circuit may operate with less capacitance and/or less drive current, thereby providing for a more effective and efficient operation, especially at high frequencies.

A drain and a source are current terminals for a field effect transistor (FET) and a gate is a control terminal for a FET. An NFET is an N type FET and a PFET is a P type FET. As used herein, two devices are coupled to each other either by being connected to each other or by being coupled through at least one other device. For example, referring to Figure 2, the drain of NFET 221 is coupled to resister 225 by being connected to resistor 225 and coupled to VDD supply voltage rail 203 through resistor 225. As used herein, a "node" of a circuit is a conductive region between two or more circuit devices and designed to have an electric potential that is essentially the same (with at most only a negligible voltage drop) along the region. As used in the claims herein, "providing" a nontransitory structure such as a clamp, resistive circuit, IC terminal, or transistor can encompass manufacturing the structure, selling or conveying the structure, implementing the structure in another item or system, or positioning the structure to be used.

Features specifically shown or described with respect to one embodiment set forth herein may be implemented in other embodiments set forth herein.

In some embodiments, an integrated circuit (IC) includes a signal IC terminal, a clamp including a first current terminal coupled to the signal IC terminal via a first current path and a second current terminal coupled to a first supply voltage rail via a second current path, a resistive circuit located in the first current path between the signal IC terminal and the first current terminal and configured to provide a resistance to the first current path, wherein a control terminal of the clamp is coupled to a voltage node, wherein when a voltage of the first current terminal of the clamp is higher by at least a first amount above a voltage of the control terminal of the clamp, the clamp becomes conductive to make conductive a discharge path between the signal IC terminal and the first supply voltage rail to reduce a voltage of the signal IC terminal with respect to a voltage of the voltage node, wherein the discharge path between the signal IC terminal and the first supply voltage rail is through the resistive circuit and is through the clamp, a first transistor including a first current terminal coupled to the control terminal of the clamp, a second current terminal coupled to the first supply voltage rail, and a control terminal configured to receive an ESD trigger signal whose assertion is indicative of a detected ESD event, wherein in response to an assertion of the ESD trigger signal, the first transistor is made conductive to pull a voltage of the control terminal of the clamp towards a voltage of the first supply voltage rail to make the clamp conductive to make conductive the discharge path between the signal IC terminal and the first supply voltage rail for discharging ESD current.

In further embodiments, the integrated circuit includes a second resistive circuit located in a path between the voltage node and the control terminal of the clamp, wherein the second resistive circuit is configured to provide a resistance to the path between the voltage node and the control terminal of the clamp.

In further embodiments, the resistive circuit is located in a signal path coupled to the signal IC terminal, wherein the signal path conveys a signal through the resistive circuit that is conveyed by the signal IC terminal during a normal operation of the integrated circuit.

In further embodiments, the clamp is implemented with a PFET.

In further embodiments, the integrated circuit includes drive circuitry for generating a signal to output externally on the signal IC terminal.

In further embodiments, the drive circuitry includes a drive node for producing the signal at the drive node, wherein the drive node is coupled via a signal path to the signal IC terminal, the signal path is through the resistive circuit.

In further embodiments, the drive node is connected to the first current terminal of the clamp and is located in the discharge path.

In further embodiments, the integrated circuit includes receiver circuitry including an input coupled via a signal path through the resistive circuit to the signal IC terminal and configured to receive a signal provided externally to the signal IC terminal.

In further embodiments, the input of the receiver circuitry is connected to the first current terminal of the clamp.

In further embodiments, when a voltage of the first current terminal of the clamp is higher by at least the first amount above the voltage of the control terminal of the clamp to make conductive the discharge path between the signal IC terminal and the first supply voltage rail to reduce the voltage of the signal IC terminal with respect to the voltage of the voltage node, the first transistor is not conductive if the ESD trigger signal is not asserted.

In further embodiments, the first transistor is implemented with an NFET.

In further embodiments, the integrated circuit further includes an ESD detection circuit, the ESD detection circuit asserts the ESD trigger signal at least in response to detecting an ESD event affecting the voltage node.

In further embodiments, the voltage node is a second voltage supply rail.

In other embodiments, a method includes providing a signal IC terminal of an integrated circuit, providing a clamp of the integrated circuit, the clamp including a first current terminal coupled to the signal IC terminal via a first current path and a second current terminal coupled to a first supply voltage rail of the integrated circuit via a second current path, providing a resistive circuit of the integrated circuit located in the first current path between the signal IC terminal and the first current terminal and configured to provide a resistance to the first current path, wherein a control terminal of the clamp is coupled to a voltage node of the integrated circuit, wherein when a voltage of the first current terminal of the clamp is higher by at least a first amount above a voltage of the control terminal of the clamp, the clamp becomes conductive to make conductive a discharge path between the signal IC terminal and the first supply voltage rail to reduce a voltage of the signal IC terminal with respect to a voltage of the voltage node, wherein the discharge path between the signal IC terminal and the first supply voltage rail is through the resistive circuit and is through the clamp, providing a first transistor of the integrated circuit including a first current terminal coupled to the control terminal of the clamp, a second current terminal coupled to the first supply voltage rail, and a control terminal configured to receive an ESD trigger signal whose assertion is indicative of a detected ESD event, wherein in response to an assertion of the ESD trigger signal, the first transistor is made conductive to pull a voltage of the control terminal of the clamp towards a voltage of the first supply voltage rail to make the clamp conductive to make conductive the discharge path between the signal IC terminal and the first supply voltage rail for discharging ESD current.

In further embodiments, the method further includes providing a second resistive circuit located in a path between the voltage node and the control terminal of the clamp, wherein the second resistive circuit is configured to provide a resistance to the path between the voltage node and the control terminal of the clamp.

In further embodiments, when a voltage of the first current terminal of the clamp is higher by at least the first amount above the voltage of the control terminal of the clamp to make conductive the discharge path between the signal IC terminal and the first supply voltage rail to reduce the voltage of the signal IC terminal with respect to the voltage of the voltage node, the first transistor is not conductive if the ESD trigger signal is not asserted.

In further embodiments, the clamp is implemented with a PFET.

In further embodiments, the resistive circuit is located in a signal path coupled to the signal IC terminal, wherein the signal path conveys a signal through the resistive circuit that is conveyed by the signal IC terminal during a normal operation of the integrated circuit.

In some embodiments, an integrated circuit (IC) includes a signal IC terminal, a PFET including a source coupled to the signal IC terminal via a first current path and a drain coupled to a first supply voltage rail via a second current path, a resistive circuit located in the first current path between the signal IC terminal and the source and configured to provide a resistance to the first current path, wherein a gate of the PFET is coupled to a second supply voltage rail, wherein when a voltage of the source is higher by at least a first amount above a voltage of the gate, the PFET becomes conductive to make conductive a discharge path between the signal IC terminal and the first supply voltage rail to reduce a voltage of the signal IC terminal with respect to a voltage of the second supply voltage rail, wherein the discharge path between the signal IC terminal and the first supply voltage rail is through the resistive circuit and is through the PFET, an NFET including a drain coupled to the gate of the PFET, a source coupled to the first supply voltage rail, and a gate configured to receive an ESD trigger signal whose assertion is indicative of a detected ESD event, wherein in response to an assertion of the ESD trigger signal, the NFET is made conductive to pull a voltage of the gate of the PFET towards a voltage of the first supply voltage rail to make the PFET conductive the discharge path between the signal IC terminal and the first supply voltage rail for discharging ESD current.

In further embodiments, the integrated circuit further includes a second resistive circuit located in a path between the second supply voltage rail and the gate of the PFET wherein the second resistive circuit is configured to provide a resistance to the path between the second supply voltage rail and the gate of the PFET.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the scope of this invention.

## Claims

1. An integrated circuit (IC) comprising:
a signal IC terminal;
a clamp including a first current terminal coupled to the signal IC terminal via a first current path and a second current terminal coupled to a first supply voltage rail via a second current path;
a resistive circuit located in the first current path between the signal IC terminal and the first current terminal and configured to provide a resistance to the first current path;
wherein a control terminal of the clamp is coupled to a voltage node, wherein when a voltage of the first current terminal of the clamp is higher by at least a first amount above a voltage of the control terminal of the clamp, the clamp becomes conductive to make conductive a discharge path between the signal IC terminal and the first supply voltage rail to reduce a voltage of the signal IC terminal with respect to a voltage of the voltage node, wherein the discharge path between the signal IC terminal and the first supply voltage rail is through the resistive circuit and is through the clamp;
a first transistor including a first current terminal coupled to the control terminal of the clamp, a second current terminal coupled to the first supply voltage rail, and a control terminal configured to receive an ESD trigger signal whose assertion is indicative of a detected ESD event, wherein in response to an assertion of the ESD trigger signal, the first transistor is made conductive to pull a voltage of the control terminal of the clamp towards a voltage of the first supply voltage rail to make the clamp conductive to make conductive the discharge path between the signal IC terminal and the first supply voltage rail for discharging ESD current.

2. The integrated circuit of claim 1, further comprising a second resistive circuit located in a path between the voltage node and the control terminal of the clamp, wherein the second resistive circuit is configured to provide a resistance to the path between the voltage node and the control terminal of the clamp.

3. The integrated circuit of claim 1 or 2, wherein the resistive circuit is located in a signal path coupled to the signal IC terminal, wherein the signal path conveys a signal through the resistive circuit that is conveyed by the signal IC terminal during a normal operation of the integrated circuit.

4. The integrated circuit of any of claims 1 to 3, wherein the clamp is implemented with a PFET.

5. The integrated circuit of any of claims 1 to 4, further comprising drive circuitry for generating a signal to output externally on the signal IC terminal.

6. The integrated circuit of claim 5, wherein the drive circuitry includes a drive node for producing the signal at the drive node, wherein the drive node is coupled via a signal path to the signal IC terminal, the signal path is through the resistive circuit.

7. The integrated circuit of claim 6, wherein the drive node is connected to the first current terminal of the clamp and is located in the discharge path.

8. The integrated circuit of any of claims 1 to 7, further includes receiver circuitry including an input coupled via a signal path through the resistive circuit to the signal IC terminal and configured to receive a signal provided externally to the signal IC terminal.

9. The integrated circuit of claim 8, wherein the input of the receiver circuitry is connected to the first current terminal of the clamp.

10. The integrated circuit of any of claims 1 to 9, wherein when a voltage of the first current terminal of the clamp is higher by at least the first amount above the voltage of the control terminal of the clamp to make conductive the discharge path between the signal IC terminal and the first supply voltage rail to reduce the voltage of the signal IC terminal with respect to the voltage of the voltage node, the first transistor is not conductive if the ESD trigger signal is not asserted.

11. The integrated circuit of any of claims 1 to 10, wherein the first transistor is implemented with an NFET.

12. The integrated circuit of any of claims 1 to 11, including an ESD detection circuit, the ESD detection circuit asserts the ESD trigger signal at least in response to detecting an ESD event affecting the voltage node.

13. The integrated circuit of any of claims 1 to 12, wherein the voltage node is a second voltage supply rail.

14. A method comprising:
providing a signal IC terminal of an integrated circuit;
providing a clamp of the integrated circuit, the clamp including a first current terminal coupled to the signal IC terminal via a first current path and a second current terminal coupled to a first supply voltage rail of the integrated circuit via a second current path;
providing a resistive circuit of the integrated circuit located in the first current path between the signal IC terminal and the first current terminal and configured to provide a resistance to the first current path;
wherein a control terminal of the clamp is coupled to a voltage node of the integrated circuit, wherein when a voltage of the first current terminal of the clamp is higher by at least a first amount above a voltage of the control terminal of the clamp, the clamp becomes conductive to make conductive a discharge path between the signal IC terminal and the first supply voltage rail to reduce a voltage of the signal IC terminal with respect to a voltage of the voltage node, wherein the discharge path between the signal IC terminal and the first supply voltage rail is through the resistive circuit and is through the clamp;
providing a first transistor of the integrated circuit including a first current terminal coupled to the control terminal of the clamp, a second current terminal coupled to the first supply voltage rail, and a control terminal configured to receive an ESD trigger signal whose assertion is indicative of a detected ESD event, wherein in response to an assertion of the ESD trigger signal, the first transistor is made conductive to pull a voltage of the control terminal of the clamp towards a voltage of the first supply voltage rail to make the clamp conductive to make conductive the discharge path between the signal IC terminal and the first supply voltage rail for discharging ESD current.

15. The method of claim 14, further comprising providing a second resistive circuit located in a path between the voltage node and the control terminal of the clamp, wherein the second resistive circuit is configured to provide a resistance to the path between the voltage node and the control terminal of the clamp.
